# EUROPEAN PATENT APPLICATION

(11) **EP 4 240 119 A1**
(43) Date of publication of application: **06.09.2023**
(21) Application number: 21886049.2
(22) Date of filing: 21.10.2021
(51) Int. Cl.: H05K 1/11

(54) **FLEXIBLE SUBSTRATE AND INSPECTION TOOL**

(30) Priority: 27.10.2020 JP 2020179352
(71) Applicant: YOKOWO CO., LTD., Kita-ku Tokyo 114-8515 (JP)
(72) Inventor: SUZUKI, Hisashi, Tokyo 114-8515 (JP); MIURA, Chikara, Tokyo 114-8515 (JP)
(74) Representative: Gunzelmann, Rainer
(86) International application number: PCT/JP2021/038915
(87) International publication number: WO 2022/091930

(57) **Abstract**

Provided are: a flexible substrate that is insusceptible to damage even when a force is partially applied thereto; and an inspection tool that uses said flexible substrate. The flexible substrate comprises: one end; the other end; and at least a pattern part (31a3) formed between the one end and the other end. The pattern part (31a3) has tongue pieces (31a4) formed by slits (S). The tongue pieces (31a4) are to be electrically connected to another member. The tongue pieces (31a4) includes a plurality of portions to be electrically connected to the other member. The tongue pieces (31a4) are each formed at an end of a signal line.

## Description

### TECHNICAL FIELD

The present invention relates to a flexible substrate and the like.

### BACKGROUND ART

In the related art, as disclosed in Patent Literature 1, a flexible substrate that is extendable has been proposed.

### CITATION LIST

### PATENT LITERATURE

Patent Literature 1: JP2020-92277A

### SUMMARY OF INVENTION

### TECHNICAL PROBLEM

However, when a force is partially applied to the flexible substrate, a part of the flexible substrate may be bent or otherwise damaged.

Therefore, an object of the present invention is to provide a flexible substrate or the like which is not easily damaged even when a force is partially applied.

### SOLUTION TO PROBLEM

A flexible substrate according to the present invention includes one end portion, the other end portion, and a pattern portion formed at least between the one end portion and the other end portion. The pattern portion has a tongue piece formed by notches. The tongue piece is configured to be electrically connected to another member.

### ADVANTAGEOUS EFFECTS OF INVENTION

As described above, according to the present invention, it is possible to provide a flexible substrate or the like which is not easily damaged even when a force is partially applied.

### BRIEF DESCRIPTION OF DRAWINGS

[Fig. 1] Fig. 1 is an exploded perspective view of an inspection jig according to the present embodiment;
[Fig. 2] Fig. 2 is an exploded perspective view of a connector contact portion, a substrate holding portion, and a substrate portion;
[Fig. 3] Fig. 3 is an exploded perspective view of a front-side substrate assembly;
[Fig. 4] Fig. 4 is a perspective view of a front-side flexible substrate as viewed from a front side and a lower side;
[Fig. 5] Fig. 5 is a perspective view of the front-side flexible substrate as viewed from a rear side and the lower side;
[Fig. 6] Fig. 6 is a perspective view of a region of the front-side flexible substrate in which a tongue piece is present, as viewed from the front side and the lower side;
[Fig. 7] Fig. 7 is an exploded perspective view of an assembly of the front-side flexible substrate and a front-side connector, a front-side holding portion, a front-side connector base, and a front-side probe group;
[Fig. 8] Fig. 8 is an exploded perspective view of a rear-side substrate assembly;
[Fig. 9] Fig. 9 is a perspective view of the inspection jig as viewed from the front side and the lower side;
[Fig. 10] Fig. 10 is a front view of the inspection jig as viewed from the front side;
[Fig. 11] Fig. 11 is a yz cross-sectional configuration view of the inspection jig and an inspection target connector in a first state, including a region where a first spring is present;
[Fig. 12] Fig. 12 is an xz cross-sectional configuration view in which a region where the tongue piece of the front-side flexible substrate in the first state is present is enlarged;
[Fig. 13] Fig. 13 is a yz cross-sectional configuration view of the inspection jig and the inspection target connector in a second state, including the region where the first spring is present;
[Fig. 14] Fig. 14 is a yz cross-sectional configuration view of the inspection jig and the inspection target connector in a third state, including the region where the first spring is present;
[Fig. 15] Fig. 15 is a yz cross-sectional configuration view of the inspection jig and the inspection target connector in a fourth state, including the region where the first spring is present;
[Fig. 16] Fig. 16 is an xz cross-sectional configuration view in which a region where the tongue piece of the front-side flexible substrate in the fourth state is present is enlarged;
[Fig. 17] Fig. 17 is a yz cross-sectional configuration view of the inspection jig and the inspection target connector in a fifth state, including the region where the first spring is present;
[Fig. 18] Fig. 18 is a perspective view of a first flexible substrate, a second flexible substrate, and a third flexible substrate;
[Fig. 19] Fig. 19 is a perspective view of a configuration in which the front-side flexible substrate is attached to the front-side holding portion, which is formed as a separate body, as viewed from an upper side at the front side;
[Fig. 20] Fig. 20 is a perspective view of a configuration in which the front-side flexible substrate implemented as a separate body is attached to the front-side holding portion, as viewed from the rear side and the upper side; and
[Fig. 21] Fig. 21 is a perspective view of a configuration in which the front-side flexible substrate implemented as a separate body is attached to the front-side holding portion and the front-side connector is attached to a connector connection end of the first flexible substrate, as viewed from the front side and the lower side.

### DESCRIPTION OF EMBODIMENTS

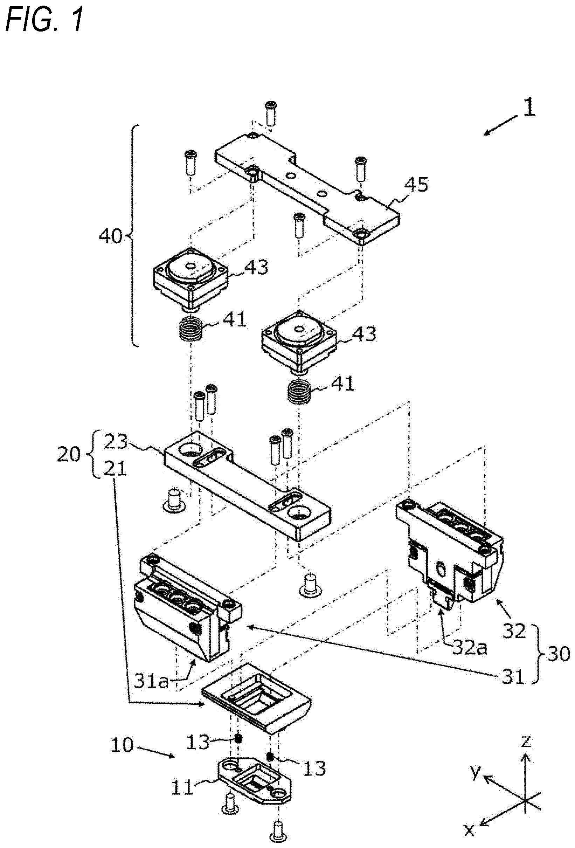

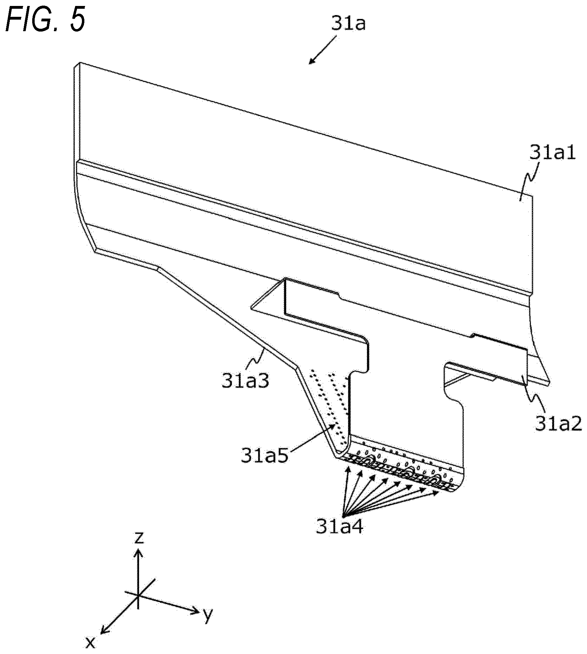

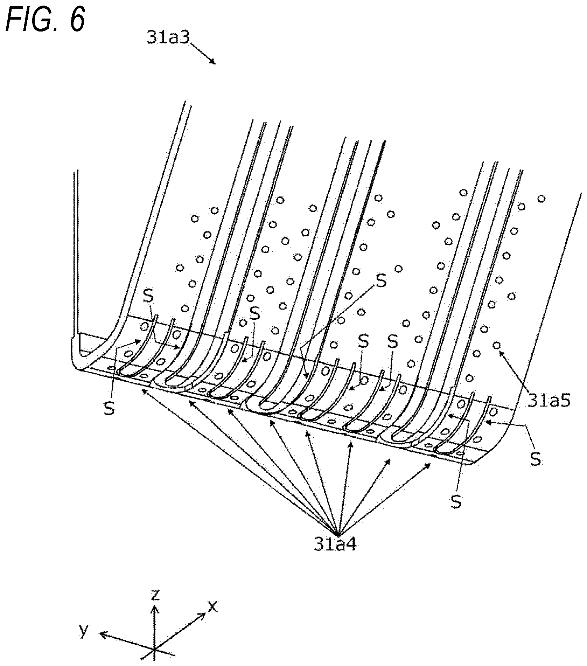

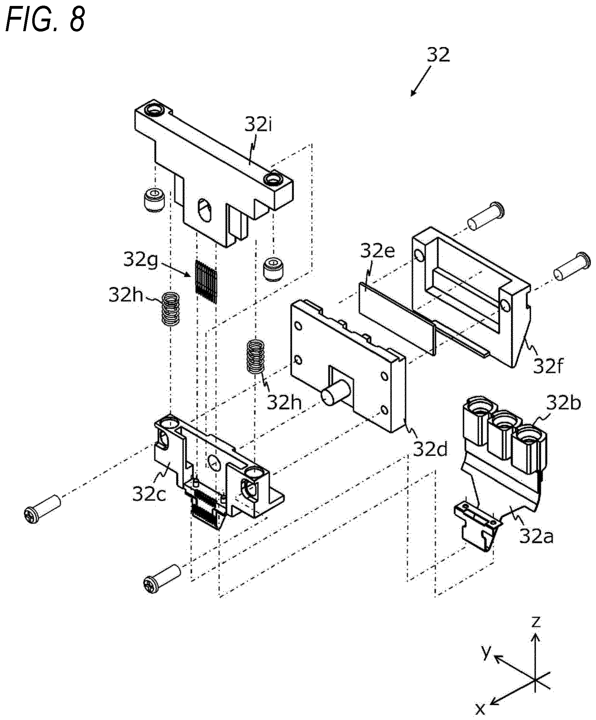

Hereinafter, the present embodiment will be described with reference to Figs. 1 to 17. The embodiments are not limited to the following embodiments. In principle, contents described in one embodiment are similarly applied to other embodiments. The embodiments and modifications may be combined as appropriate.

### <Inspection Jig 1>

As illustrated in Fig. 1, an inspection jig 1 in the present embodiment includes a connector contact portion 10, a substrate holding portion 20, a substrate portion 30, and a horizontal position adjusting portion 40. The inspection jig 1 is brought into contact with an inspection target connector (B to B connector: Board to Board connector) 100 to be inspected via the connector contact portion 10, and is electrically connected to a front-side flexible substrate 31a and a rear-side flexible substrate 32a inside. In Fig. 1, the inspection target connector 100 is not illustrated.

In order to describe directions, a horizontal direction (front-rear direction) in which two substrate assemblies (front-side substrate assembly 31 and rear-side substrate assembly 32) are arranged is referred to as an x direction, a direction (left-right direction) that is perpendicular to the x direction and has two support portions 43 arranged therein is referred to as a y direction, and a direction (up-down direction) perpendicular to the x direction and the y direction is referred to as a z direction. In Fig. 1, directions indicated by respective arrows of xyz axes are defined as a forward direction, a rightward direction, and an upward direction, respectively. Specifically, a direction from the rear-side substrate assembly 32 toward the front-side substrate assembly 31 is defined as the forward direction. In addition, of the two support portions 43, a direction from the support portion 43 positioned at the lower right in Fig. 1 to the support portion 43 positioned at the upper left in Fig. 1 is defined as the rightward direction. Further, a direction from the connector contact portion 10 toward the horizontal position adjusting portion 40 is defined as the upward direction.

### <Connector Contact Portion 10>

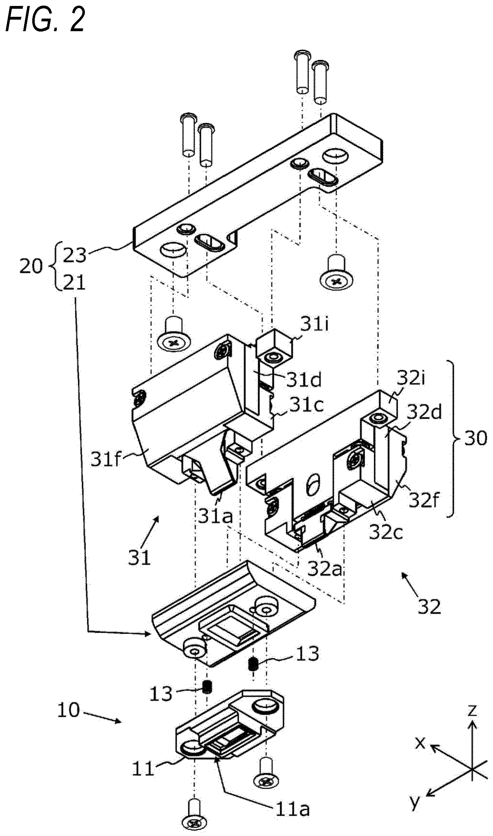

As illustrated in Fig. 2, the connector contact portion 10 includes a floating guide (first movable member) 11 and the first spring (first elastic member) 13. The floating guide 11 has a hole penetrating in the z direction. A lower end of a lower-side holding portion 21 and a lower end of the substrate portion 30 are inserted into the hole of the floating guide 11 from an upper side in the z direction. An upper end of the inspection target connector 100 is inserted into the hole of the floating guide 11 from a lower side in the z direction. That is, the inspection target connector 100 is attached to the floating guide 11 in a detachable state.

In order to facilitate insertion of the inspection target connector 100, it is desirable that a guide portion 11a having an inclined shape in which an opening on the lower side in the z direction is gradually enlarged be provided on a lower side of the hole of the floating guide 11 in the z direction.

The upper side of the floating guide 11 in the z direction is attached to the lower-side holding portion 21 by screwing. The first spring 13 is provided between the floating guide 11 and the lower-side holding portion 21. The first spring 13 biases the floating guide 11 away from the front-side flexible substrate 31a and the rear-side flexible substrate 32a in the z direction. Therefore, the floating guide 11 and the lower-side holding portion 21 are maintained in a separated state by the first spring 13 unless a force is applied in a direction of contraction in the z direction, such as pushing the inspection jig 1 into the inspection target connector 100 from the upper side in the z direction.

### <Substrate Holding Portion 20>

The substrate holding portion 20 includes the lower-side holding portion (pin block frame) 21 and an upper-side holding portion (connection plate) 23. The lower-side holding portion 21 is provided on the lower side of the substrate portion 30 in the z direction. The upper-side holding portion 23 is provided on the upper side of the substrate portion 30 in the z direction. The lower-side holding portion 21 and the upper-side holding portion 23 sandwich the substrate portion 30 in the z direction.

The lower-side holding portion 21 has a hole penetrating in the z direction. The lower end of the substrate portion 30 is inserted into the hole of the lower-side holding portion 21 from the upper side in the z direction. A convex portion is formed on the lower side of the lower-side holding portion 21 in the z direction. The convex portion is fitted into the hole of the floating guide 11 from the upper side in the z direction.

A front-side holding portion 31c of the front-side substrate assembly 31 and a rear-side holding portion 32c of the rear-side substrate assembly 32 are attached to the upper side of the lower-side holding portion 21 in the z direction. An attachment of the front-side holding portion 31c to the lower-side holding portion 21 is performed by fitting and bonding using a boss hole. An attachment of the rear-side holding portion 32c to the lower-side holding portion 21 is performed by bonding.

A front-side push block 31i of the front-side substrate assembly 31 and a rear-side push block 32i of the rear-side substrate assembly 32 are attached to the lower side of the upper-side holding portion 23 in the z direction. An attachment of the front-side push block 31i to the upper-side holding portion 23 is performed from the upper side in the z direction and by screwing that uses a round hole. An attachment of the rear-side push block 32i to the upper-side holding portion 23 is performed from the upper side in the z direction and by screwing that uses an elongated hole extending in the x direction. The elongated hole extending in the x direction of the upper-side holding portion 23 is used to adjust an interval in the x direction between the front-side holding portion 31c that holds the front-side push block 31i and the rear-side holding portion 32c that holds the rear-side push block 32i.

The interval in the x direction between the front-side holding portion 31c and the rear-side holding portion 32c is determined in accordance with an interval in the x direction between electrode positions of the inspection target connector 100. When the interval in the x direction between electrodes of the inspection target connector 100 is narrow, the attachments of the front-side holding portion 31c and the rear-side holding portion 32c to the lower-side holding portion 21, and the attachments of the front-side push block 31i and the rear-side push block 32i to the upper-side holding portion 23 are performed in a state where the interval in the x direction between the front-side holding portion 31c and the rear-side holding portion 32c is narrow. When the interval in the x direction between electrodes of the inspection target connector 100 is wide, the attachments of the front-side holding portion 31c and the rear-side holding portion 32c to the lower-side holding portion 21, and the attachments of the front-side push block 31i and the rear-side push block 32i to the upper-side holding portion 23 are performed in a state where the interval in the x direction between the front-side holding portion 31c and the rear-side holding portion 32c is wide.

That is, the substrate holding portion 20 holds a plurality of flexible substrates (front-side flexible substrate 31a and rear-side flexible substrate 32a) in a state where the interval in the x direction is adjustable.

### <Substrate Portion 30>

The substrate portion 30 includes the front-side substrate assembly 31 and the rear-side substrate assembly 32. The front-side substrate assembly 31 is disposed on a front side in the x direction, and the rear-side substrate assembly 32 is disposed on a rear side in the x direction.

### <Front-side Substrate Assembly 31>

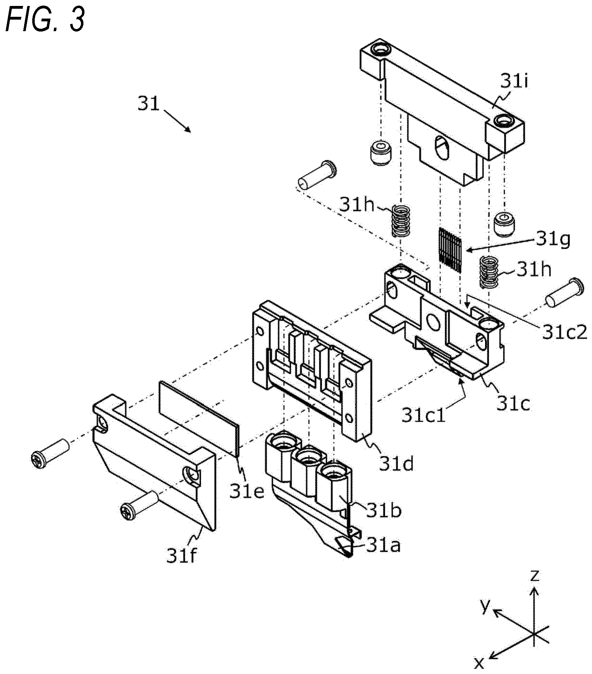

As illustrated in Fig. 3, the front-side substrate assembly 31 includes the front-side flexible substrate (flexible substrate) 31a, a front-side connector 31b, the front-side holding portion 31c, a front-side connector base 31d, a front-side connector presser rubber 31e, a front-side connector cover 31f, a front-side probe group 31g, front-side second springs 31h, and the front-side push block (second movable member) 31i.

### <Front-side Flexible Substrate 31a>

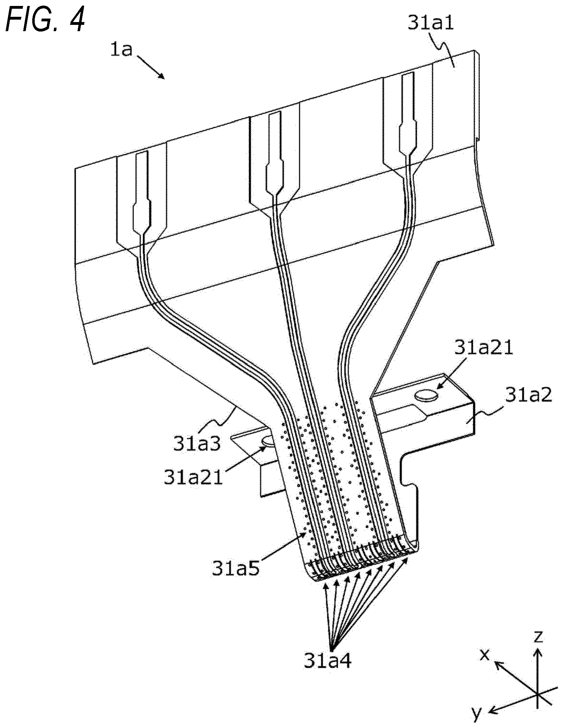

As illustrated in Figs. 4 to 6, the front-side flexible substrate 31a includes a connector connection end (one end portion) 31a1, a holding portion connection end (the other end portion) 31a2, and a pattern portion 31a3.

The connector connection end 31a1 is an end portion of the front-side flexible substrate 31a on the front side in the x direction and on the upper side in the z direction, and the front-side connector 31b is attached to the connector connection end 31a1 by soldering or the like. The holding portion connection end 31a2 is an end portion of the front-side flexible substrate 31a on the rear side in the x direction and on the upper side in the z direction, and is latched to the front-side holding portion 31c. Specifically, holes 31a21 provided in the holding portion connection end 31a2 are fitted into bosses 31c3 provided on the upper side of a probe receptacle 31c1 of the front-side holding portion 31c in the z direction. However, latching of the holding portion connection end 31a2 and the front-side holding portion 31c is not limited to fitting of the holes 31a21 and the bosses 31c3.

The pattern portion 31a3 is a region between the connector connection end 31a1 and the holding portion connection end 31a2. A pattern of a signal line extending from the connector connection end 31a1 and a ground wire is formed on a surface on the lower side (surface side) of the pattern portion 31a3 in the z direction. The pattern portion 31a3 is bent so as to have a substantially V shape when viewed from the y direction. On a surface on the lower side of the pattern portion 31a3 in the z direction, end portions of the signal line and the ground wire are provided at a lower end portion that is in a state of being bent so as to have a substantially V shape. The end portions of the signal line and the ground wire are used as substrate-side electrodes that are electrically connected to the electrodes of the inspection target connector 100. In addition, slits S are provided around the end portions of the signal line and the ground wire (region including a portion of the pattern portion 31a3 electrically connected to the inspection target connector 100). Tongue pieces 31a4 having a substantially U shape are formed by the slits S. The slit S is a notch (cut) of which both ends are closed ends, but may have an open end at one end and a closed end at the other end. The pattern provided on the surface on the lower side (surface side) of the pattern portion 31a3 in the z direction is not limited to the signal line and the ground wire. On the surface on the lower side (surface side) of the pattern portion 31a3 in the z direction, a plurality of through holes 31a5 and a ground wire may be provided only in a region (region including the tongue piece 31a4) to be connected to the inspection target connector 100 and a region of the connector connection end 31a1 where the front-side connector 31b is soldered. In this case, since a region where the ground wire is provided is reduced, the cost is reduced as compared with a case where the pattern of the ground wire is provided on an entire surface on the lower side (surface side) of the pattern portion 31a3 in the z direction.

In order to increase an amount of displacement to the lower side in the z direction by probes P of the front-side probe group 31g to be described later, it is desirable to increase a length in a longitudinal direction of the slits S forming the tongue pieces 31a4. On the other hand, in order to prevent characteristics of the signal line in a high frequency region from being deteriorated, it is desirable to shorten the length in the longitudinal direction of the slits S forming the tongue pieces 31a4. Therefore, the length in the longitudinal direction of the slits S forming the tongue pieces 31a4 is determined in consideration of the amount of displacement to the lower side in the z direction of the tongue pieces 31a4 and the characteristics of the signal line in the high frequency region. In one tongue piece 31a4, only one signal line, one ground wire, or one power line may be provided, or at least one of the signal line, the ground wire, and the power line may be provided in plural.

The tongue piece 31a4 formed by the slit S is not limited to the substantially U shape. As long as the pattern portion 31a3 can be displaced from the upper side in the z direction to the lower side in the z direction by the probes P of the front-side probe group 31g in a state where the pattern portion 31a3 does not extend, the tongue piece 31a4 may have other shapes such as a substantially V shape, a substantially C shape, a substantially L shape, and a substantially groove shape.

On a surface on the upper side (back side) of the pattern portion 31a3 in the z direction, that is, on a side opposite to a side electrically connected to the inspection target connector 100, a ground wire different from the ground wire on the surface on the lower side (surface side) in the z direction, or a ground plane is provided. In the pattern portion 31a3, a plurality of through holes 31a5 for electrically connecting the surface on the upper side in the z direction and the surface on the lower side in the z direction are provided. Figs. 4 to 6 illustrate examples in which the plurality of through holes 31a5 are provided. However, an arrow line of a member number "31a5" indicates only one of the plurality of through holes 31a5.

In a case where a plurality of through holes 31a5 are provided in the pattern portion 31a3, even when another member is electrically connected only to one surface side (side electrically connected to another member: surface side) of the pattern portion 31a3, the other surface side (side opposite to the side electrically connected to the another member: back side) of the pattern portion 31a3 can be electrically connected to another member.

Depending on a specification of the inspection target connector 100, the ground wire or the ground plane on the surface on the upper side of the pattern portion 31a3 in the z direction and the plurality of through holes 31a5 may be omitted. In addition, in drawings other than Figs. 4 to 6, illustrations of the signal line and the ground wire of the pattern portion 31a3, the slits S, the tongue pieces 31a4, and the through holes 31a5 are omitted.

In addition, the plurality of through holes 31a5 and a grounded region (ground wire or ground plane) on the upper side (back side) in the z direction may be provided only in the region (region including the tongue piece 31a4) to be connected to the inspection target connector 100 and the region of the connector connection end 31a1 where the front-side connector 31b is soldered.

### <Front-side Connector 31b>

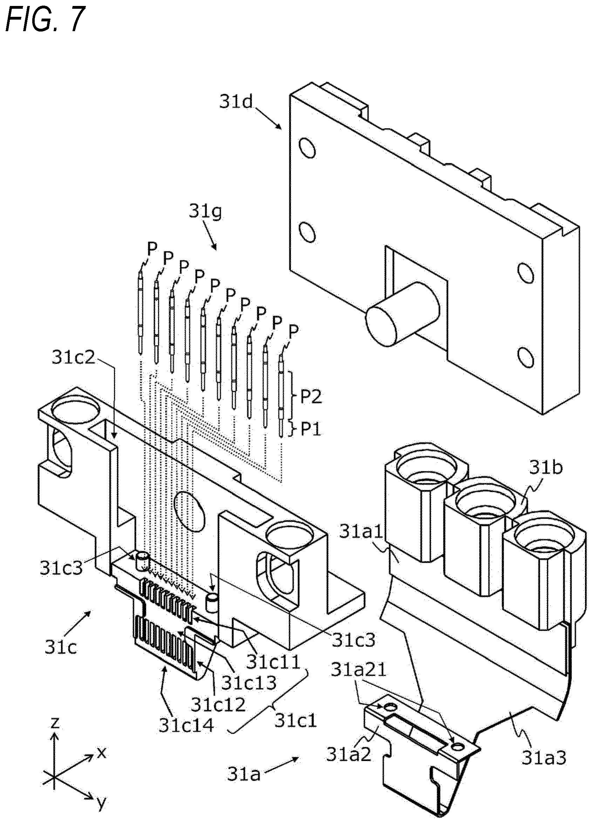

As illustrated in Fig. 7, the front-side connector 31b is attached to the connector connection end 31a1 of the front-side flexible substrate 31a. The front-side connector 31b is used for electrically connecting the front-side flexible substrate 31a to an inspection device (not illustrated).

### <Front-side Holding Portion 31c>

The front-side holding portion 31c holds the front-side connector base 31d on the front side in the x direction. The front-side holding portion 31c holds the holding portion connection end 31a2 of the front-side flexible substrate 31a on the rear side in the x direction.

### <Probe Receptacle 31 c1 >

On the rear side in the x direction and on the lower side in the z direction of the front-side holding portion 31c, a probe receptacle 31c1 that holds the front-side probe group 31g is provided. The probe receptacle 31c1 is formed of a resin material. When the probe receptacle 31c1 is formed of a resin material, the probe receptacle 31c1 is lighter in weight, easier in processing, and less expensive than when the probe receptacle 31c1 is formed of a metal material. Incidentally, the probe receptacle 31c1 may be formed of a metal material.

The probe receptacle 31c1 includes grooves (upper groove portion 31c11 and lower groove portion 31c12) extending in the z direction and holes (upper hole portion 31c13 and lower hole portion 31c14) extending in the z direction. Widths of the upper groove portion 31c11 and the lower groove portion 31c12 in the x direction and the y direction are larger than an outer diameter of a spring accommodation portion (barrel) P2 of the probes P constituting the front-side probe group 31g. An upper end of the upper hole portion 31c13 communicates with a lower end of the upper groove portion 31c11, and a lower end of the upper hole portion 31c13 communicates with an upper end of the lower groove portion 31c12. An inner diameter of the upper hole portion 31c13 is larger than the outer diameter of the spring accommodation portion P2 of the probes P constituting the front-side probe group 31g. An upper end of the lower hole portion 31c14 communicates with a lower end of the lower groove portion 31c12, and a lower end of the lower hole portion 31c14 is open. An inner diameter of the lower hole portion 31c14 is larger than an outer diameter of a distal end portion P1 of the probes P constituting the front-side probe group 31g and smaller than the outer diameter of the spring accommodation portion P2.

### <Method for Forming Probe Receptacle 31 c1 >

The upper groove portion 31c11 and the lower groove portion 31c12 are formed by a metal mold. Holes of the upper hole portion 31c13 and the lower hole portion 31c14 are formed by punching holes in a rectangular parallelepiped region using pins or the like. However, the method for forming the probe receptacle 31c1 is not limited to the above-described method.

### <Attachment of Front-side Flexible Substrate 31a to Front-side Holding Portion 31c>

The front-side flexible substrate 31a is attached to the front-side holding portion 31c so as to satisfy the following two conditions. First condition: the lower side of the front-side holding portion 31c in the z direction faces the surface on the upper side of the pattern portion 31a3 of the front-side flexible substrate 31a in the z direction. Second condition: the end portions of the signal line and the ground wire of the pattern portion 31a3 of the front-side flexible substrate 31a are positioned on the lower side of the lower hole portion 31c14 of the probe receptacle 31c1 of the front-side holding portion 31c in the z direction.

### <Push Block Groove Portion 31c2>

A groove (push block groove portion 31c2) opened to the upper side in the z direction is provided on the upper side of the probe receptacle 31c1 of the front-side holding portion 31c in the z direction. The front-side push block 31i is inserted into the push block groove portion 31c2 from the upper side in the z direction (see Fig. 3).

### <Boss 31c3>

The bosses 31c3 extending upward in the z direction is provided on the upper side of the probe receptacle 31c1 of the front-side holding portion 31c in the z direction. The bosses 31c3 are used for latching the holding portion connection end 31a2 of the front-side flexible substrate 31a.

### <Front-side Connector Base 31d>

The front-side connector base 31d holds the front-side connector 31b on the front side in the x direction. The front-side connector base 31d is positioned on the front side in the x direction with respect to the front-side holding portion 31c, and is attached to the front-side holding portion 31c.

An assembly of the front-side flexible substrate 31a and the front-side connector 31b is attached to an assembly of the front-side holding portion 31c and the front-side connector base 31d so as to sandwich the front-side holding portion 31c and the front-side connector base 31d in the x direction and to wrap the lower end of the front-side holding portion 31c. An attachment of the front-side holding portion 31c to the front-side connector base 31d is performed by screwing from the rear side in the x direction.

### <Front-side Connector Presser Rubber 31e>

The front-side connector presser rubber 31e is provided between the front-side connector 31b and the front-side connector cover 31f. The front-side connector presser rubber 31e is used to minimize an adverse effect on electrical connection with the inspection device due to variations in height of the front-side connector 31b. The front-side connector presser rubber 31e is used to make the front-side connector 31b difficult to move when a cable extending from the inspection device is attached to or detached from the front-side connector 31b.

### <Front-side Connector Cover 31f>

The front-side connector cover 31f covers the pattern portion 31a3 of the front-side flexible substrate 31a and the front side of the front-side connector 31b in the x direction. An attachment of the front-side connector cover 31f to the front-side connector base 31d is performed by screwing from the front side in the x direction. The front-side connector cover 31f and the front-side connector base 31d sandwich the front-side connector 31b and the front-side connector presser rubber 31e in the x direction.

### <Front-side Probe Group 31g>

The front-side probe group 31g includes a plurality of probes (extendable members) P that extend and contract in the z direction. The plurality of probes P are arranged in the y direction. Each of the probes P constituting the front-side probe group 31g has the distal end portion P1 on the lower side in the z direction, and has the spring accommodation portion P2 on the upper side in the z direction with respect to the distal end portion P1. A spring (not illustrated) is accommodated in the spring accommodation portion P2. The distal end portion P1 is biased by the spring in the spring accommodation portion P2 in a direction in which an entire length of the distal end portion P1 extends.

When each of the probes P constituting the front-side probe group 31g is placed on the probe receptacle 31c1 of the front-side holding portion 31c in a state where the front-side flexible substrate 31a is not attached to the front-side holding portion 31c, the distal end portion P1 of the probes P protrudes toward the lower side in the z direction from the holes (lower hole portion 31c14) of the lower end portion of the probe receptacle 31c1. However, since the spring accommodation portion P2 is held by a step between the lower hole portion 31c14 and the lower groove portion 31c12, the probes P do not fall from the lower hole portion 31c14.

When each of the probes P constituting the front-side probe group 31g is placed on the probe receptacle 31c1 of the front-side holding portion 31c in a state where the front-side flexible substrate 31a is attached to the front-side holding portion 31c, the distal end portion P1 of the probes P comes into contact with the back side of the region where the tongue pieces 31a4 of the front-side flexible substrate 31a are present. For example, among the plurality of probes P, a first probe P is in a positional relation of being in contact with one of regions (one of the tongue pieces 31a4) of the front-side flexible substrate 31a electrically connected to the inspection target connector 100. In addition, among the plurality of probes P, a second probe P different from the first probe P is in a positional relation of being in contact with one of the regions (one of the tongue pieces 31a4) of the front-side flexible substrate 31a electrically connected to the inspection target connector 100, that is, a tongue piece 31a4 different from the tongue piece 31a4 corresponding to the first probe P. However, since the probe P is light, the probe P is only in contact with the tongue piece 31a4, and hardly displaces the tongue piece 31a4 to the lower side in the z direction.

An attachment of the assembly of the front-side flexible substrate 31a and the front-side connector 31b to the assembly of the front-side holding portion 31c and the front-side connector base 31d is performed in a state where each of the probes P constituting the front-side probe group 31g is placed on the probe receptacle 31c1.

### <Front-side Second Spring 31h and Front-side Push Block 31i>

The front-side push block 31i is inserted into the groove (push block groove portion 31c2) of the front-side holding portion 31c from the upper side in the z direction in a state where the front-side push block 31i is movable in the z direction. The front-side push block 31i is used to push down each of the probes P constituting the front-side probe group 31g toward the lower side in the z direction. That is, the plurality of probes P constituting the front-side probe group 31g are provided between the front-side flexible substrate 31a and the front-side push block 31i. The front-side second spring 31h is provided between the front-side holding portion 31c and the front-side push block 31i. The front-side second spring 31h biases the front-side push block 31i away from the front-side holding portion 31c in the z direction.

Spring characteristics (spring pressure, spring constant, and the like) of the first spring 13, the front-side second spring 31h, and a rear-side second spring 32h are set such that when a force is applied in the direction of contraction in the z direction, compressions of the front-side second spring 31h and the later-described rear-side second spring 32h in the z direction are completed after compression of the first spring 13 in the z direction is completed. That is, after the first spring 13 contracts, the front-side second spring 31h and the rear-side second spring 32h contract.

That is, when the front-side flexible substrate 31a and the rear-side flexible substrate 32a are connected to the inspection target connector 100, operations of the floating guide 11, the front-side flexible substrate 31a, and the rear-side flexible substrate 32a are controlled by the first spring 13, the front-side second spring 31h, and the rear-side second spring 32h in the following manner. After a first distance d1 between the floating guide 11 and the front-side flexible substrate 31a and the rear-side flexible substrate 32a is shortened, a second distance d2 between the front-side push block 31i and the front-side flexible substrate 31a is shortened, and at substantially the same timing, a second distance d2 between the rear-side push block 32i and the rear-side flexible substrate 32a is shortened.

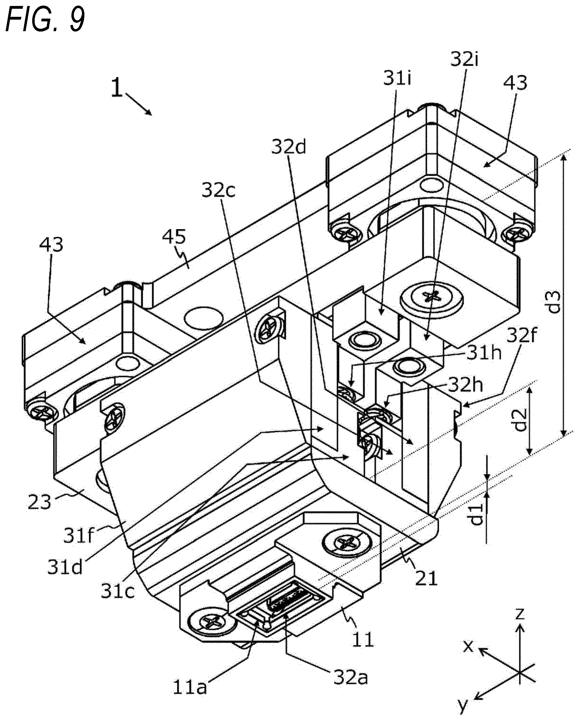

For example, the first distance d1 is a distance in the z direction between a lower end portion (opening region into which the inspection target connector 100 is inserted) of the floating guide 11 and a lower end portion (region of the pattern portion 31a3 electrically connected to the inspection target connector 100) of the front-side flexible substrate 31a. For example, the second distance d2 is a distance in the z direction between a lower end portion (region in contact with the front-side probe group 31g) of the front-side push block 31i and a lower end portion (region of the pattern portion 31a3 electrically connected to the inspection target connector 100) of the front-side flexible substrate 31a (see Fig. 9).

Therefore, even when a force is applied to the inspection target connector 100 in the direction of contraction in the z direction, such as pushing the inspection jig 1 from the upper side in the z direction, the front-side push block 31i and the front-side holding portion 31c are maintained in a separated state by the front-side second spring 31h, and the rear-side push block 32i and the rear-side holding portion 32c are maintained in a separated state by the rear-side second spring 32h, as long as the first spring 13 does not contract.

### <Rear-side Substrate Assembly 32>

The rear-side substrate assembly 32 includes the rear-side flexible substrate (flexible substrate) 32a, a rear-side connector 32b, the rear-side holding portion 32c, a rear-side connector base 32d, a rear-side connector presser rubber 32e, a rear-side connector cover 32f, a rear-side probe group 32g, the rear-side second spring 32h, and the rear-side push block (second movable member) 32i.

A configuration of the rear-side substrate assembly 32 is the same as a configuration of the front-side substrate assembly 31 except that an orientation of the x direction is reversed. The rear-side flexible substrate 32a of the rear-side substrate assembly 32 corresponds to the front-side flexible substrate 31a of the front-side substrate assembly 31. The rear-side connector 32b of the rear-side substrate assembly 32 corresponds to the front-side connector 31b of the front-side substrate assembly 31. The rear-side holding portion 32c of the rear-side substrate assembly 32 corresponds to the front-side holding portion 31c of the front-side substrate assembly 31. The rear-side connector base 32d of the rear-side substrate assembly 32 corresponds to the front-side connector base 31d of the front-side substrate assembly 31. The rear-side connector presser rubber 32e of the rear-side substrate assembly 32 corresponds to the front-side connector presser rubber 31e of the front-side substrate assembly 31. The rear-side connector cover 32f of the rear-side substrate assembly 32 corresponds to the front-side connector cover 31f of the front-side substrate assembly 31. The rear-side probe group 32g of the rear-side substrate assembly 32 corresponds to the front-side probe group 31g of the front-side substrate assembly 31. The rear-side second spring 32h of the rear-side substrate assembly 32 corresponds to the front-side second spring 31h of the front-side substrate assembly 31. The rear-side push block 32i of the rear-side substrate assembly 32 corresponds to the front-side push block 31i of the front-side substrate assembly 31.

### <Horizontal Position Adjusting Portion 40>

The horizontal position adjusting portion 40 includes a third spring (third elastic member) 41, the support portion (third movable member) 43, and a bracket 45 (see Fig. 1).

### <Third Spring 41 and Support Portion 43>

Two support portions 43 are provided in the y direction. Each of the two support portions 43 incorporates an annular coil spring (not illustrated).

The support portion 43 is used to absorb a deviation from a position facing the electrodes of the inspection target connector 100 in the z direction regarding a region where the tongue piece 31a4 of the front-side flexible substrate 31a of the front-side substrate assembly 31 is present and a region where the tongue piece of the rear-side flexible substrate 32a of the rear-side substrate assembly 32 is present.

For example, it is assumed that the region where the tongue piece 31a4 of the front-side flexible substrate 31a of the front-side substrate assembly 31 is present and the region where the tongue piece of the rear-side flexible substrate 32a of the rear-side substrate assembly 32 is present are deviated on an xy plane from the position facing the electrodes of the inspection target connector 100 in the z direction. In this case, when the inspection jig 1 is attached to the inspection target connector 100, the connector contact portion 10, the substrate holding portion 20, and the substrate portion 30 can move on the xy plane without moving the horizontal position adjusting portion 40.

An attachment of the support portion 43 to the upper-side holding portion 23 is performed by screwing from the lower side in the z direction. The third spring 41 is provided between the support portion 43 and the upper-side holding portion 23. The third spring 41 biases the support portion 43 away from the upper-side holding portion 23 in the z direction.

Spring characteristics (spring pressure, spring constant, and the like) of the first spring 13, the front-side second spring 31h, the rear-side second spring 32h, and the third spring 41 are set such that when a force is applied in the direction of contraction in the z direction, compression of the third spring 41 in the z direction is completed after compressions of the first spring 13, the front-side second spring 31h, and the rear-side second spring 32h in the z direction are completed. That is, after the first spring 13, the front-side second spring 31h, and the rear-side second spring 32h contract, the third spring 41 contracts.

That is, when the front-side flexible substrate 31a and the rear-side flexible substrate 32a are connected to the inspection target connector 100, operations of the floating guide 11, the front-side push block 31i, the rear-side push block 32i, and the support portion 43 are controlled by the first spring 13, the front-side second spring 31h, the rear-side second spring 32h, and the third spring 41 in the following manner. After the first distance d1 between the floating guide 11 and the front-side flexible substrate 31a and the rear-side flexible substrate 32a is shortened, the second distance d2 between the front-side push block 31i and the front-side flexible substrate 31a is shortened, and at substantially the same timing, the second distance d2 between the rear-side push block 32i and the rear-side flexible substrate 32a is shortened. After the second distance d2 between the front-side push block 31i and the front-side flexible substrate 31a is shortened and the second distance d2 between the rear-side push block 32i and the rear-side flexible substrate 32a is shortened, a third distance d3 between the support portion 43 and the front-side flexible substrate 31a and the rear-side flexible substrate 32a is shortened.

For example, the third distance d3 is a distance in the z direction between a lower end portion (region facing the upper-side holding portion 23 in the z direction) of the support portion 43 and the lower end portion (region of the pattern portion 31a3 electrically connected to the inspection target connector 100) of the front-side flexible substrate 31a.

Therefore, even when a force is applied to the inspection target connector 100 in the direction of contraction in the z direction, such as pushing the inspection jig 1 from the upper side in the z direction, the support portion 43 and the upper-side holding portion 23 are maintained in a separated state by the third spring 41 as long as the first spring 13, the front-side second spring 31h, and the rear-side second spring 32h do not contract.

As an example of the spring characteristics, the spring characteristics of each spring may be set such that the spring pressure of the third spring 41 is higher than the spring pressures of the front-side second spring 31h and the rear-side second spring 32h, and the spring pressures of the front-side second spring 31h and the rear-side second spring 32h is higher than the spring pressure of the first spring 13.

In addition, as an example of the spring characteristics, the spring characteristics of each spring may be set such that a combined spring constant (elastic coefficient) of two third springs 41 is larger than a combined spring constant (elastic coefficient) of two front-side second springs 31h and two rear-side second springs 32h, and a combined spring constant (elastic coefficient) of two front-side second springs 31h and two rear-side second springs 32h is larger than a combined spring constant (elastic coefficient) of two first springs 13.

### <Bracket 45>

The bracket 45 is attached to a device (not illustrated) that holds and moves the inspection jig 1, such as an inspection device or a machine tool. The bracket 45 is attached to the upper side of the two support portions 43 in the z direction. An attachment of the bracket 45 to the support portions 43 is performed by screwing from the upper side in the z direction.

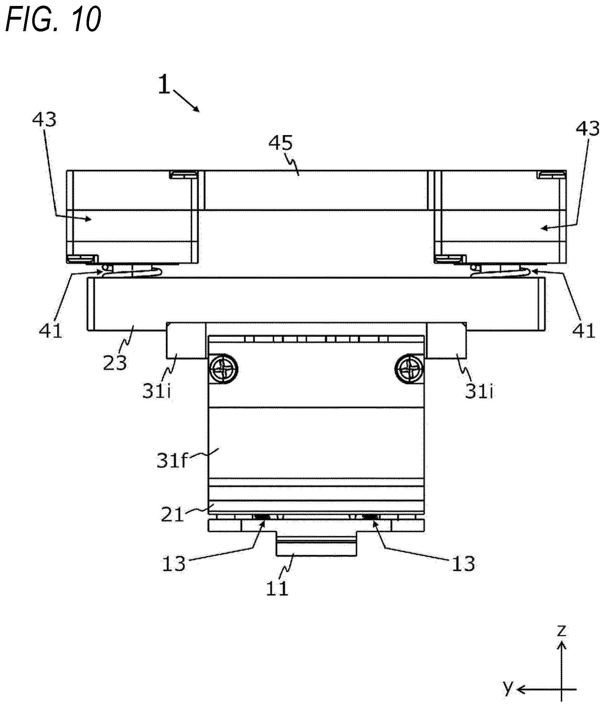

As illustrated in Figs. 9 and 10, the first spring 13, the front-side second spring 31h, and the rear-side second spring 32h are disposed such that a part of the first spring 13 is visible from the outside, and such that the front-side second spring 31h and the rear-side second spring 32h are hardly visible from the outside (not visible from the front side in the x direction and the rear side in the x direction). In addition, the third spring 41 is disposed such that at least a part of the third spring 41 can be seen from the outside in an extended state.

### <Material for Each Portion, Metal Component, and Resin Component>

Among members constituting the inspection jig 1, the front-side probe group 31g, the rear-side probe group 32g, screws, and conductive regions such as the front-side flexible substrate 31a are made of metal. Other members constituting the inspection jig 1 are made of a non-conductive member such as a resin

### <Procedure of Connecting Inspection Jig 1 to Inspection Target Connector 100>

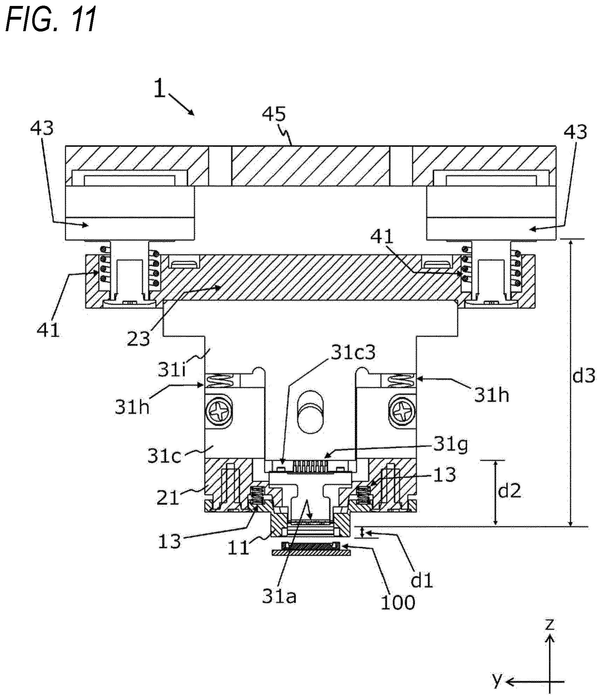

Next, a change in an extension/contraction state of the first spring 13 and the like when the inspection jig 1 is moved from the upper side in the z direction to the lower side in the z direction to be connected to the inspection target connector 100 will be described (Figs. 11 to 17).

The rear-side second spring 32h is not illustrated in yz cross-sectional configuration views of Figs. 11, 13 to 15, and 17. However, the rear-side second spring 32h is positioned on the rear side of the front-side second spring 31h in the x direction, and extends and contracts in the same manner as the front-side second spring 31h. The rear-side push block 32i is not illustrated in the yz cross-sectional configuration views of Figs. 11, 13 to 15, and 17. However, the rear-side push block 32i is positioned on the rear side of the front-side push block 31i in the x direction, and moves in the same manner as the front-side push block 31i. In addition, the rear-side probe group 32g is not illustrated in the yz cross-sectional configuration views of Figs. 11, 13 to 15, and 17. However, the rear-side probe group 32g is positioned on the rear side of the front-side probe group 31g in the x direction, and operates in the same manner as the front-side probe group 31g. In addition, the tongue piece of the rear-side flexible substrate 32a is not illustrated. However, the tongue piece of the rear-side flexible substrate 32a is positioned on the rear side of the tongue piece 31a4 of the front-side flexible substrate 31a in the x direction, and is displaced in the same manner as the tongue piece 31a4 of the front-side flexible substrate 31a.

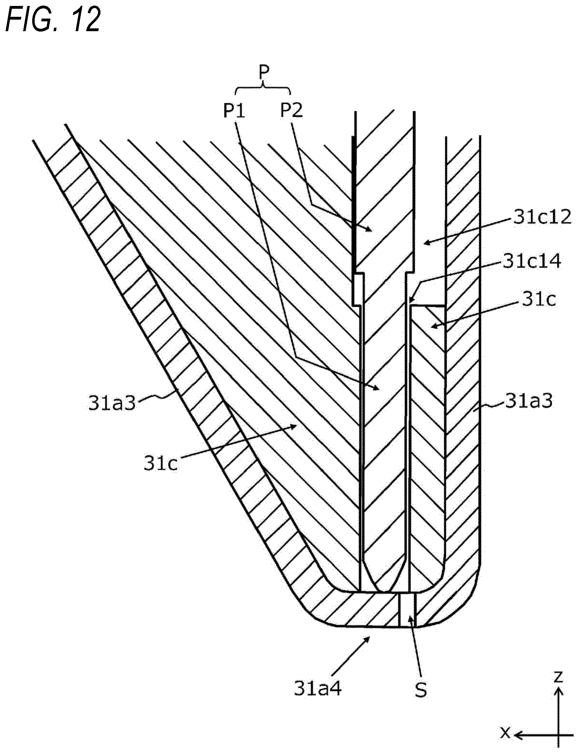

As illustrated in Fig. 11, before the inspection jig 1 comes into contact with the inspection target connector 100, the first spring 13, the front-side second spring 31h, the rear-side second spring 32h, and the third spring 41 are in an extended state, and the first distance d1, the second distance d2, and the third distance d3 are not shortened (first state). In this case, the distal end portion P1 on the lower side of the probe P constituting the front-side probe group 31g in the z direction is in contact with the tongue piece 31a4 of the front-side flexible substrate 31a (see Fig. 12). However, since the probe P is light, the tongue piece 31a4 of the front-side flexible substrate 31a is hardly pressed to the lower side in the z direction. Similarly, the distal end portion P1 on the lower side of the probe P constituting the rear-side probe group 32g in the z direction is in contact with the tongue piece of the rear-side flexible substrate 32a. However, since the probe P is light, the tongue piece of the rear-side flexible substrate 32a is hardly pressed to the lower side in the z direction.

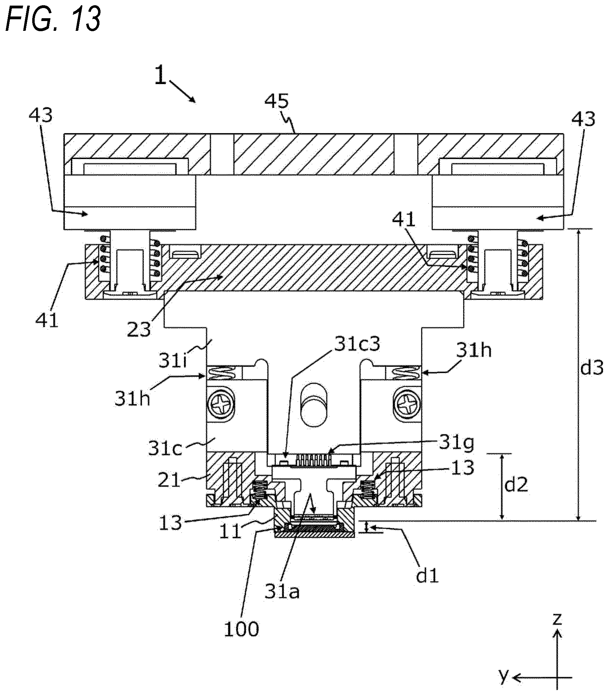

As illustrated in Fig. 13, immediately after the inspection target connector 100 is fitted into the holes of the floating guide 11 of the inspection jig 1, the first spring 13, the front-side second spring 31h, the rear-side second spring 32h, and the third spring 41 are in an extended state, and the first distance d1, the second distance d2, and the third distance d3 are not shortened (second state). In this case, the front-side flexible substrate 31a and the rear-side flexible substrate 32a are not in contact with the inspection target connector 100.

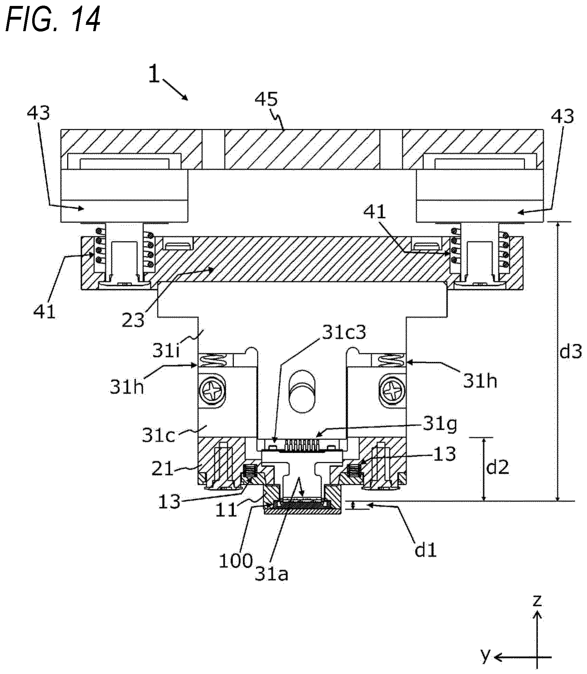

As illustrated in Fig. 14, when the inspection jig 1 further moves to the lower side in the z direction from the second state, the first spring 13 contracts in the z direction, and the lower-side holding portion 21 is brought close to the floating guide 11 (third state).

In this case, the front-side flexible substrate 31a and the rear-side flexible substrate 32a are in a state of being close to the inspection target connector 100. Therefore, the first distance d1 in the third state is shorter than the first distance d1 in the second state. However, the front-side second spring 31h, the rear-side second spring 32h, and the third spring 41 are hardly contracted. Therefore, the second distance d2 in the third state is hardly shorter than the second distance d2 in the second state. The third distance d3 in the third state is hardly shorter than the third distance d3 in the second state.

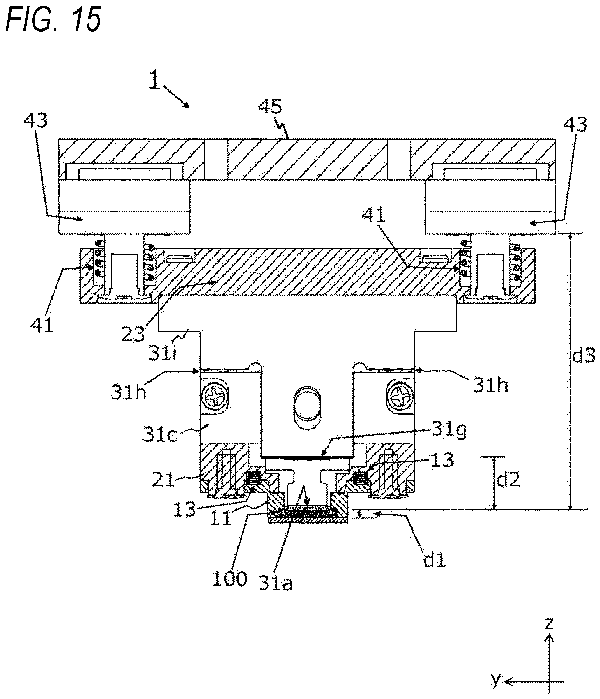

As illustrated in Fig. 15, when the inspection jig 1 further moves to the lower side in the z direction from the third state, the front-side second spring 31h contracts in the z direction, and the front-side push block 31i is brought close to the front-side holding portion 31c (fourth state). Similarly, the rear-side second spring 32h contracts in the z direction, and the rear-side push block 32i is brought close to the rear-side holding portion 32c.

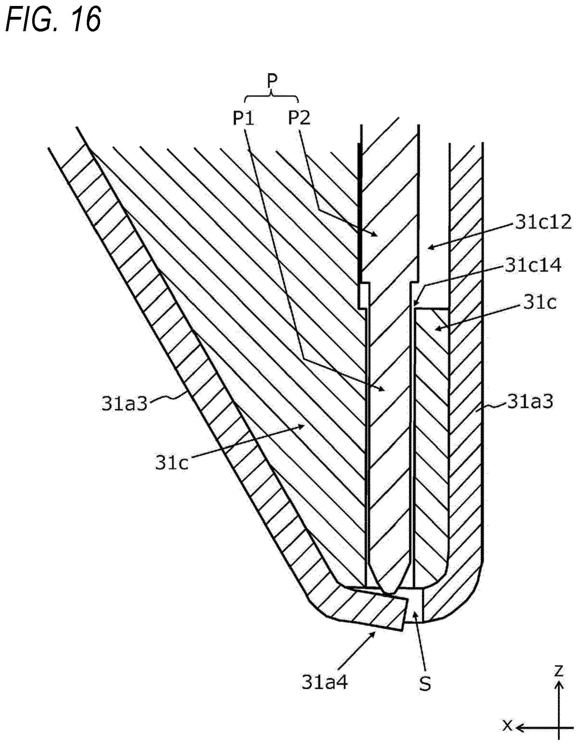

When the front-side push block 31i moves to the lower side in the z direction, the probes P of the front-side probe group 31g move to the lower side in the z direction, and the distal end portion P1 of the probes P pushes the back side (upper side in the z direction) of the front-side flexible substrate 31a. As a result, the tongue piece 31a4 of the front-side flexible substrate 31a is pushed to the lower side in the z direction (see Fig. 16). That is, the tongue piece 31a4 of the front-side flexible substrate 31a is brought close to the electrode of the inspection target connector 100 by the probes P of the front-side probe group 31g. Similarly, when the rear-side push block 32i moves to the lower side in the z direction, the probes P of the rear-side probe group 32g move to the lower side in the z direction, and the distal end portions P1 of the probes P pushes the back side (upper side in the z direction) of the rear-side flexible substrate 32a. As a result, the tongue piece of the rear-side flexible substrate 32a is pushed to the lower side in the z direction. That is, the tongue piece of the rear-side flexible substrate 32a is brought close to the electrode of the inspection target connector 100 by the probes P of the rear-side probe group 32g.

As a result, the front-side flexible substrate 31a and the rear-side flexible substrate 32a are in a state of being electrically connected to the inspection target connector 100. The first distance d1 in the fourth state is further shorter than the first distance d1 in the third state. In addition, the front-side push block 31i and the rear-side push block 32i are pushed down to the lowermost end of a movable range in the z direction. Therefore, the second distance d2 in the fourth state is shorter than the second distance d2 in the third state. However, the third spring 41 is hardly contracted. Therefore, the third distance d3 in the fourth state is hardly shorter than the third distance d3 in the third state.

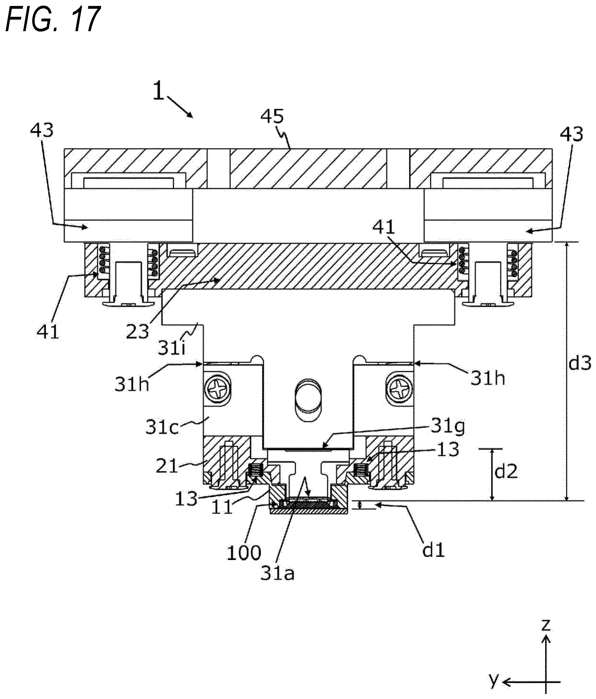

As illustrated in Fig. 17, when the inspection jig 1 further moves to the lower side in the z direction from the fourth state, the third spring 41 contracts in the z direction, and the support portion 43 and the bracket 45 are brought close to the upper-side holding portion 23 (fifth state). In this case, the support portion 43 is in a state of being close to the upper-side holding portion 23. Therefore, the third distance d3 in the fifth state is shorter than the third distance d3 in the fourth state.

Whether the front-side second spring 31h and the rear-side second spring 32h are in a contracted state cannot be visually recognized from the front side in the x direction and the rear side in the x direction. In addition, whether the front-side push block 31i and the rear-side push block 32i have moved to the lower side in the z direction cannot be visually recognized from the front side in the x direction and the rear side in the x direction. However, a part of the third spring 41 can be visually recognized from the outside at least in the extended state. Therefore, by observing a region where the third spring 41 is present from the outside, it is possible to confirm whether the third spring 41 starts to contract greatly, that is, whether a movement of the front-side push block 31i and the like to the lower side in the z direction is completed and the front-side flexible substrate 31a and the rear-side flexible substrate 32a are in a state of being electrically connected to the inspection target connector 100.

### <Effect of Using Two-stage Elastic Member in Inspection Jig 1>

First, the inspection target connector 100 is brought close to the front-side flexible substrate 31a and the rear-side flexible substrate 32a via the floating guide 11, and then the front-side flexible substrate 31a and the rear-side flexible substrate 32a are connected to the inspection target connector 100 using the front-side push block 31i, the rear-side push block 32i, the probes P, and the like. Therefore, the front-side flexible substrate 31a and the rear-side flexible substrate 32a included in the inspection jig 1 can be electrically connected to the inspection target connector 100 without largely deforming or displacing the front-side flexible substrate 31a and the rear-side flexible substrate 32a. That is, the front-side flexible substrate 31a and the rear-side flexible substrate 32a included in the inspection jig 1 can be electrically connected to the inspection target connector 100 in a state where the inspection jig 1 including the front-side flexible substrate 31a and the rear-side flexible substrate 32a is not easily damaged.

### <Effect of Providing Support Portion 43 and Bracket 45>

The inspection jig 1 can be attached to a machine tool or the like via the support portion 43, the bracket 45, and the like.

### <Effect of Disposing Third Spring 41 at Visible Portion>

After the compressions of the first spring 13, the front-side second spring 31h, and the rear-side second spring 32h are completed, it is possible to determine whether the connection between the front-side flexible substrate 31a and the rear-side flexible substrate 32a and the inspection target connector 100 is completed by observing a degree of extension or contraction of the third spring 41 in which contraction due to the compression increases. Therefore, the front-side flexible substrate 31a and the rear-side flexible substrate 32a can be connected to the inspection target connector 100 only by applying a minimum necessary force to the front-side flexible substrate 31a and the rear-side flexible substrate 32a.

### <Effect of Providing Plurality of Flexible Substrates>

The inspection target connector 100 in which the electrodes are arranged in a plurality of rows can be electrically connected to a plurality of flexible substrates (front-side flexible substrate 31a and rear-side flexible substrate 32a). In addition, the inspection jig 1 can be implemented in a state where the interval between the plurality of flexible substrates (front-side flexible substrate 31a and rear-side flexible substrate 32a) is adjusted in accordance with an interval between the plurality of rows.

### <Effect of Individually Performing Pressing with Probe P>

In consideration of variations in height of portions (electrodes) of the signal line or the ground wire that are in contact with the inspection target connector 100, it is possible to reliably connect the respective electrodes to the inspection target connector 100 by individually pressing an extendable member such as the probe P against each electrode.

### <Effect of Providing Tongue Piece on Front-side Flexible Substrate 31a and Rear-side Flexible Substrate 32a>

In order to absorb the variations in height of the electrodes, when the extendable member such as the probe P is pressed and a force is partially applied, the tongue piece 31a4 of the front-side flexible substrate 31a formed in a region including a portion to which the force is applied is separated from another region adjacent to the tongue piece 31a4 of the front-side flexible substrate 31a via the slit S, and is displaced in the pressed direction (lower side in the z direction). In addition, the tongue piece of the rear-side flexible substrate 32a formed in the region including the portion to which the force is applied is separated from another region adjacent to the tongue piece of the rear-side flexible substrate 32a via the slit S, and is displaced in the pressed direction (lower side in the z direction). Therefore, as compared with a case where the tongue piece is not provided, the flexible substrates (front-side flexible substrate 31a and rear-side flexible substrate 32a) are less likely to be damaged even when displaced.

### <Effect of Including Plurality of Electrodes in One Tongue Piece>

Since the number of the slits S can be reduced as compared with a mode in which only one electrode is provided in one tongue piece 31a4, the tongue piece 31a4 can be easily formed in a narrow region or the like. The same applies to the tongue piece of the rear-side flexible substrate 32a.

### <Effect of Using End Portion as Electrode>

When electrical connection with another member is performed in the middle of the signal line, a portion between the connection portion and the end portion may function as an antenna to perform reception and transmission of noise. By performing electrical connection with another member in the vicinity of the end portion, it is possible to reduce the reception and transmission of noise. When electrical connection with another member is performed in the middle of the ground wire, impedance matching may collapse.

### <Application Example of Shape of Flexible Substrate>

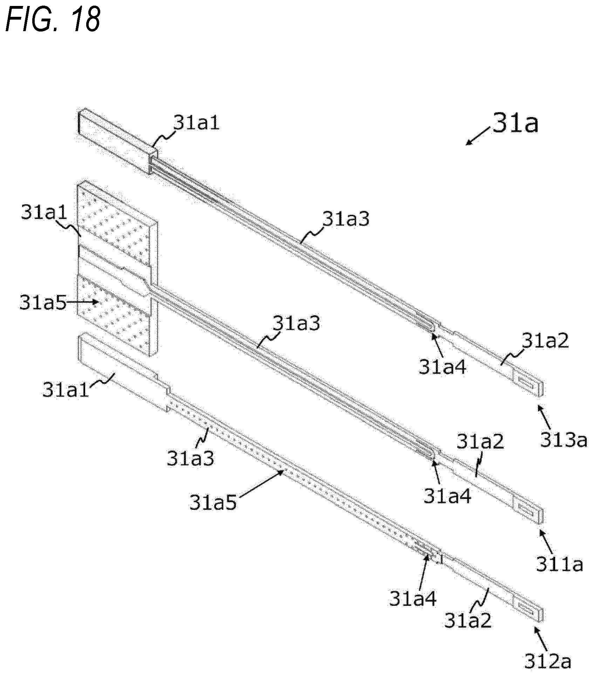

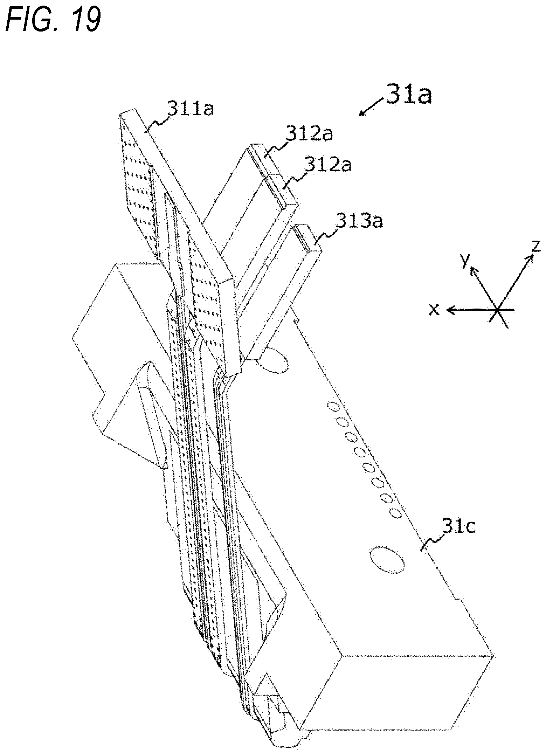

In the present embodiment, an example in which the flexible substrate (front-side flexible substrate 31a and rear-side flexible substrate 32a) is implemented by one piece of flexible substrate has been described. However, the flexible substrate may be implemented by a plurality of flexible substrates (see Figs. 18 to 21).

For example, the front-side flexible substrate 31a includes a first flexible substrate 311a including a signal line for an RF line, a second flexible substrate 312a including a ground wire for a ground line, and a third flexible substrate 313a including a power line for a power supply line. The first flexible substrate 311a, the second flexible substrate 312a, and the third flexible substrate 313a are formed as separate bodies. Each of the first flexible substrate 311a, the second flexible substrate 312a, and the third flexible substrate 313a includes the connector connection end (one end portion) 31a1, the holding portion connection end (the other end portion) 31a2, and the pattern portion 31a3. In addition, the tongue piece 31a4 is formed in each of the pattern portions 31a3 of the first flexible substrate 311a, the second flexible substrate 312a, and the third flexible substrate 313a. The through holes 31a5 are provided in the connector connection end 31a1 of the first flexible substrate 311a. In addition, the through holes 31a5 are provided in the pattern portion 31a3 of the second flexible substrate 312a.

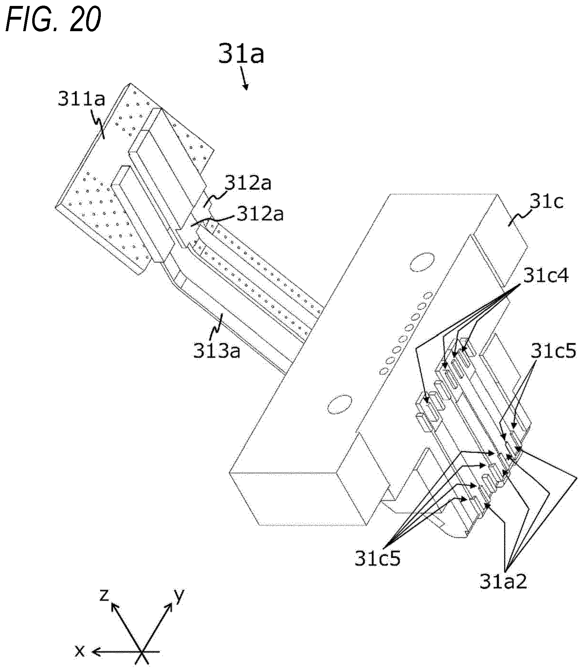

The latching of the holding portion connection end 31a2 and the front-side holding portion 31c is performed in the following manner. As illustrated in Fig. 20, a plurality of upper protrusions 31c4 and a plurality of lower protrusions 31c5 are provided on the rear side of the front-side holding portion 31c in the x direction. A constricted portion provided at the holding portion connection end 31a2 is fitted into the lower protrusion 31c5. A hole provided on a distal end side with respect to the constricted portion of the holding portion connection end 31a2 is fitted into the upper protrusion 31c4. The upper protrusion 31c4 is used for alignment (positioning in the longitudinal direction) in fixing of the holding portion connection end 31a2 and positioning in the x direction at the time of the fixing. The lower protrusion 31c5 is positioned at the lower side with respect to the upper protrusion 31c4 in the z orientation direction, and is used for positioning in the y direction at the time of the fixing. Since the positioning in the y direction is performed with the lower protrusion 31c5 closer to the tongue piece 31a4 than the upper protrusion 31c4, it is possible to accurately position the front-side flexible substrate 31a as compared with a mode in which the positioning in the y direction is performed at a position away from the tongue piece 31a4.

### <Effect of Flexible Substrate being Formed of Plurality of Flexible Substrates>

By being implemented as separate bodies, it is easy to use flexible substrates that can be shared corresponding to connectors (front-side connector 31b and rear-side connector 32b) of various shapes, the inspection device, and the inspection target connector 100. As a result, the number of cases where flexible substrates having special shapes are individually prepared is reduced, which can contribute to reduction of cost such as manufacturing cost. In addition, by implementing the flexible substrates as separate bodies, even when a partial area of one flexible substrate has a wide portion and causes physical interference with another flexible substrate on the same plane, the partial area can be shifted such that the partial area does not physically interfere with the another flexible substrate.

In examples of Figs. 18 to 21, a partial area (connector connection end 31a1) of the first flexible substrate 311a has a wide portion. Therefore, it is not easy to implement the connector connection end 31a1 of the first flexible substrate 311a and the connector connection ends 31a1 of the second flexible substrate 312a and the third flexible substrate 313a on the same plane while avoiding physical interference. However, since the first flexible substrate 311a, the second flexible substrate 312a, and the third flexible substrate 313a are implemented as separate bodies, the pattern portion 31a3 of the second flexible substrate 312a and the pattern portion 31a3 of the third flexible substrate 313a can be bent in a state where the pattern portion 31a3 of the first flexible substrate 311a is not bent. As a result, the connector connection end 31a1 of the first flexible substrate 311a can be implemented on a different plane while avoiding physical interference with the connector connection ends 31a1 of the second flexible substrate 312a and the third flexible substrate 313a.

### <Effect of Using Flexible Substrate>

In the present embodiment, flexible substrates (front-side flexible substrate 31a and rear-side flexible substrate 32a) are used as substrates electrically connected to the front-side connector 31b or the rear-side connector 32b. Therefore, when electrical connection is performed between a line of the front-side connector 31b or the rear-side connector 32b and a line of the flexible substrate by soldering or the like, the flexible substrate is bent, so that an angle at which the two lines intersect in a region where the two lines are connected to each other can be freely set. For example, the electrical connection is performed in a state where the two lines are positioned on substantially the same straight line in a region where the two lines are connected to each other. In this case, it is possible to make deterioration of high frequency characteristics such as a reflection effect less likely to occur, as compared with a mode in which the electrical connection is performed in a positional relation in which the two lines are orthogonal to each other in the region where the two lines are connected to each other.

In the present embodiment, at the connector connection end 31a1 of the front-side flexible substrate 31a, a line extending from the pattern portion 31a3 (line extending from a region of the front-side flexible substrate 31a electrically connected to the inspection target connector 100) and a line of the front-side connector 31b attached to the connector connection end 31a1 (line of a member attached to the one end portion of the front-side flexible substrate 31a) are electrically connected to each other in a state of being positioned on the same straight line. Similarly, at the connector connection end of the rear-side flexible substrate 32a, a line extending from the pattern portion (line extending from a region of the rear-side flexible substrate 32a electrically connected to the inspection target connector 100) and a line of the rear-side connector 32b attached to the connector connection end (line of a member attached to the one end portion of the rear-side flexible substrate 32a) are electrically connected to each other in a state of being positioned on the same straight line.

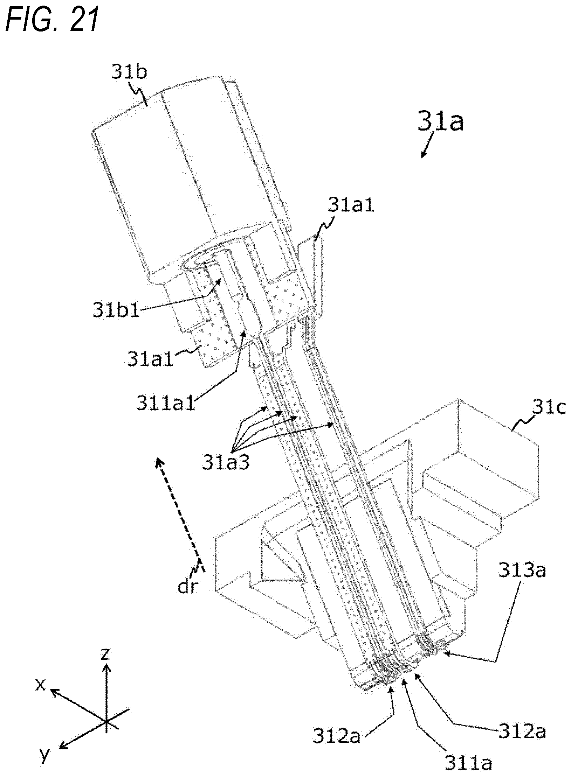

Fig. 21 illustrates an example in which at the connector connection end 31a1 of the front-side flexible substrate 31a, a line (signal line 311a1) of the first flexible substrate 311a of the front-side flexible substrate 31a and the connection terminal 31b1 of a member for connection to the first flexible substrate 31a of the front-side connector 31b are electrically connected to each other in a state of being positioned substantially parallel to each other, that is, substantially on the same straight line. A region of the line extending from the pattern portion 31a3 and connected to the line of the front-side connector 31b, and a region of the line of the front-side connector 31b and connected to the line extending from the pattern portion 31a3 extend along the same direction. For example, a line (signal line 311a1) extending from the pattern portion 31a3 of the first flexible substrate 311a and a line (connection terminal 31b1) of the front-side connector 31b extend along a predetermined direction dr in a region where the two lines are connected. The predetermined direction dr is parallel to a line connecting a region on the rear side in the x direction and on the lower side in the z direction and a region on the front side in the x direction and on the upper side in the z direction, and forms a predetermined angle with a yz plane and an xy plane.

### <Other Embodiments: Extendable Members Other than Probe>

In the present embodiment, a mode is described in which the probe P is used as an extendable member that presses the front-side flexible substrate 31a from the back side (upper side in the z direction) to the lower side in the z direction and an extendable member that presses the rear-side flexible substrate 32a from the back side (upper side in the z direction) to the lower side in the z direction. However, the extendable member is not limited to the probe P, and other elastic members may be used as long as the member is extendable in the z direction.

### <Other Embodiments: Not Limited to Two Rows of Probes>

In the present embodiment, a mode is described in which the front-side probe group 31g and the rear-side probe group 32g are arranged in the x direction, that is, the probe group arranged in the y direction is arranged in two rows in the x direction. However, the number of rows of the probe group may be one row or three or more rows in accordance with arrangement of the electrodes of the inspection target connector 100.

### <Other Embodiments: Elastic Members Other than Spring>

In the present embodiment, a mode is described in which the first spring 13 is provided between the floating guide 11 and the lower-side holding portion 21, the front-side second spring 31h is provided between the front-side holding portion 31c and the front-side push block 31i, the rear-side second spring 32h is provided between the rear-side holding portion 32c and the rear-side push block 32i, and the third spring 41 is provided between the upper-side holding portion 23 and the support portion 43. However, the extendable member is not limited to the spring, and other elastic members may be used as long as the member is extendable in the z direction.

Certain embodiments of the present invention have been described, but these embodiments have been presented by way of example only, and are not intended to limit the scope of the invention. These embodiments can be implemented in various other forms, and various omissions, replacements, and modifications can be made without departing from the gist of the invention. These embodiments and modifications thereof are included in the scope of the invention or the gist of the invention, and are included in a scope equivalent to the invention described in the claims.

According to the present specification, the following aspects are provided.

### (Aspect 1)

A flexible substrate includes one end portion, the other end portion, and a pattern portion formed at least between the one end portion and the other end portion. The pattern portion has a tongue piece formed by notches. The tongue piece is configured to be electrically connected to another member.

In a case where an extendable member such as a probe is pressed and a force is partially applied, a tongue piece of the flexible substrate formed in a region including a portion to which the force is applied is separated from another region adjacent to the tongue piece of the flexible substrate via a notch, and is displaced in the pressed direction.

Therefore, as compared with a case where the tongue piece is not provided, the flexible substrate is less likely to be damaged even when a force is partially applied.

### (Aspect 2)

Preferably, the tongue piece is provided with a plurality of portions electrically connected to the another member.

Since the number of notches can be reduced as compared with a mode in which only one electrode is provided in one tongue piece, the tongue piece can be easily formed in a narrow region or the like.

### (Aspect 3)

More preferably, the tongue piece is formed at an end portion of a signal line.

When electrical connection with the another member is performed in the middle of the signal line, a portion between the connection portion and the end portion may function as an antenna to perform reception and transmission of noise. By performing electrical connection with another member in the vicinity of the end portion, it is possible to reduce the reception and transmission of noise.

### (Aspect 4)

More preferably, the pattern portion is provided with a plurality of through holes for electrically connecting a side electrically connected to the another member and a side opposite to the side electrically connected to the another member.

The flexible substrate often has a structure in which the signal line is provided on one surface side and a ground wire is provided on the other surface side. In a case where a plurality of through holes are provided in the pattern portion, even when the another member is electrically connected only to one surface side (side electrically connected to the another member) of the pattern portion, the other surface side (side opposite to the side electrically connected to the another member) of the pattern portion can be electrically connected to the another member.

### (Aspect 5)

More preferably, at the one end portion, a line extending from the pattern portion and a line of a member attached to the one end portion are configured to be electrically connected in a state of being positioned on the same straight line.

### (Aspect 6)

More preferably, the flexible substrate according to any one of aspects 1 to 4 and an extendable member are provided. When the extendable member presses the back side of the region including the portion electrically connected to the another member, the tongue piece is electrically connected to the another member.

### (Aspect 7)

More preferably, an inspection jig includes a first movable member. The another member is brought close to the flexible substrate via the first movable member. The tongue piece is brought closer to the another member by the extendable member.

The another member is brought close to the flexible substrate via the first movable member, and the tongue piece of the flexible substrate is connected to the another member using the extendable member such as a probe. Therefore, it is possible to electrically connect the flexible substrate included in the inspection jig and the another member without largely moving the flexible substrate, that is, in a state where the flexible substrate is not easily damaged.

### REFERENCE SIGNS LIST

1: inspection jig
10: connector contact portion
11: floating guide (first movable member)
11a: guide portion
13: first spring (first elastic member)
20: substrate holding portion
21: lower-side holding portion (pin block frame)
23: upper-side holding portion (connection plate)
30: substrate portion
31: front-side substrate assembly
31a: front-side flexible substrate (flexible substrate)
311a: first flexible substrate
311a1: signal line
312a: second flexible substrate
313a: third flexible substrate
31a1: connector connection end
31a2: holding portion connection end
31a21: hole
31a3: pattern portion
31a4: tongue piece
31a5: through hole
31b: front-side connector
31b1: connection terminal
31c: front-side holding portion
31c1: probe receptacle
31c11: upper groove portion
31c12: lower groove portion
31c13: upper hole portion
31c14: lower hole portion
31c2: push block groove portion
31c3: boss
31c4: upper protrusion
31c5: lower protrusion
31d: front-side connector base
31e: front-side connector presser rubber
31f: front-side connector cover
31g: front-side probe group
31h: front-side second spring (second elastic member)
31i: front-side push block (second movable member)
32: rear-side substrate assembly
32a: rear-side flexible substrate (flexible substrate)
32b: rear-side connector
32c: rear-side holding portion
32d: rear-side connector base
32e: rear-side connector presser rubber
32f: rear-side connector cover
32g: rear-side probe group
32h: rear-side second spring (second elastic member)
32i: rear-side push block (second movable member)
40: horizontal position adjusting portion
41: third spring
43: support portion
45: bracket
100: inspection target connector
d1: first distance
d2: second distance
d3: third distance
dr: predetermined direction
P: probe (extendable member)
P1: distal end portion
P2: spring accommodation portion
S: Slit

## Claims

1. A flexible substrate, comprising:
one end portion;
the other end portion; and
a pattern portion formed at least between the one end portion and the other end portion, wherein
the pattern portion has a tongue piece formed by a notch, and
the tongue piece is configured to be electrically connected to another member.

2. The flexible substrate according to claim 1, wherein the tongue piece is provided with a plurality of portions electrically connected to the another member.

3. The flexible substrate according to claim 1 or 2, wherein the tongue piece is formed at an end portion of a signal line.

4. The flexible substrate according to any one of claims 1 to 3, wherein the pattern portion is provided with a plurality of through holes for electrically connecting a side electrically connected to the another member and a side opposite to the side electrically connected to the another member.

5. The flexible substrate according to any one of claims 1 to 4, wherein at the one end portion, a line extending from the pattern portion and a line of a member attached to the one end portion are configured to be electrically connected in a state of being positioned on the same straight line.

6. An inspection jig, comprising:
the flexible substrate according to any one of claims 1 to 5; and
an extendable member, wherein
the extendable member presses a back side of a region including a portion electrically connected to the another member, whereby the tongue piece is electrically connected to the another member.

7. The inspection jig according to claim 6, further comprising a first movable member, wherein
the another member is brought close to the flexible substrate via the first movable member, and
the tongue piece is brought close to the another member by the extendable member.
